# EUROPEAN PATENT SPECIFICATION

(11) **EP 1 709 456 B1**
(45) Date of publication and mention of the grant of the patent: **11.11.2009**
(21) Application number: 04799241.7
(22) Date of filing: 25.11.2004
(51) Int. Cl.: G01R 33/09, G01N 27/74

(54) **MAGNETIC-FIELD-SENSITIVE SENSOR ARRANGEMENT**
MAGNETFELDEMPFINDLICHE SENSORANORDNUNG
ENSEMBLE A CAPTEUR SENSIBLE AUX CHAMPS MAGNETIQUES

(30) Priority: 04.12.2003 EP 03104536
(43) Date of publication of application: 11.10.2006
(73) Proprietor: NXP B.V., 5656 AG Eindhoven (NL)
(72) Inventor: BUCHHOLD, Reinhard c/o Philips Intel. P.& S. Gmbh, 52066 Aachen (DE); DOESCHER, Michael c/o Philips Intel. P.& S. Gmbh, 52066 Aachen (DE); BUTZMANN, Stefan c/o Philips Intel. P.& S. Gmbh, 52066 Aachen (DE)
(74) Representative: Schouten, Marcus Maria
(86) International application number: PCT/IB2004/052546
(87) International publication number: WO 2005/054887

(56) References cited:
- EP-A- 0 573 372
- DE-A1- 19 919 681
- US-A- 4 712 064
- US-A- 5 051 695
- US-A- 5 351 028
- US-A- 5 686 837
- US-A- 5 719 494
- US-A1- 2003 141 957
- US-A1- 2003 151 406
- "Magnetoresistive sensors for magnetic field measurement" PHILIPS SEMICONDUCTORS, September 2000 (2000-09), pages 1-29, XP002321067
- RIPKA P ET AL: "AMR magnetometer" JOURNAL OF MAGNETISM AND MAGNETIC MATERIALS, ELSEVIER, AMSTERDAM, NL, vol. 254-255, January 2003 (2003-01), pages 639-641, XP004396659 ISSN: 0304-8853

## Description

The invention relates to a magnetic-field-sensitive sensor arrangement.

German patent application 101 41 371.8 discloses a magnetoresistive sensor device comprising at least one sensor element for measuring a magnetic field and a stabilizing magnet assigned to the sensor element. Said document furthermore mentions using magnetoresistive sensor devices as proximity sensors, movement sensors or position sensors. In this case, use is made of an external magnetic field which gives rise to a proportional voltage signal of the sensor element in the event of a change in the position of the object that is to be detected relative to the source of the external magnetic field. Such magnetoresistive sensor devices are used, for example, to detect reference marks when measuring a crankshaft angle.

According to what is stated in German patent application 101 41 371.8, the sensor elements which measure the magnetic field usually do not operate in the region of their saturation and are based on the principle of the anisotropic magnetoresistive effect. Such sensor elements are also referred to as AMR sensors. It is known to superpose on these sensor elements a magnetic field which stabilizes the transfer characteristic, this usually being effected by a stabilizing magnet assigned to the sensor element. In the case of passive, ferromagnetic objects that are to be detected, the magnet furthermore provides a field of action, the change in which under the effect of the object is detected. In this case, magnet and sensor element are in a defined fixed position relative to one another.

German laid-open specification 31 45 542 discloses a paramagnetic oxygen sensor which allows the selective measurement of oxygen in gas mixtures on the basis of the striking paramagnetic property compared to other gases. This gives rise to a change in inductance in the field of a high-frequency coil. The weak effect requires measures to keep disruptive influences small. A number of high-frequency coils are provided which, screened thermally and mechanically from the environment in a housing, have good thermal coupling with one another. They are operated in a bridge circuit, while their induction fields run in pairs in the measurement gas and a reference gas. The coils are designed in a thermally stable manner as printed silver coils on ceramic supports. Measurement gas and reference gas are guided in reflective quartz tubes in a gas-tight manner relative to the coils. In one design, the tubes run through the interior of the coils. In another design, the coils are located on both sides of a rotating plate, whereas the tubes are guided in a string-like manner past the plate in the induction field. This oxygen sensor is provided for use in particular in respiratory protection, diving equipment and medicine.

The manufacture of such a sensor is associated with high technical outlay.

US 5,051,695 A discloses a thin film vector magnetometer that is configured to produce an output voltage that varies linearly with the component of a magnetic field in the plane thereof along a predefined sensitivity axis. The thin film vector magnetometer comprises a magnetoresistive bridge which is configured in a traditional Wheatstone bridge topography and a bias magnet. Another thin film magnetometer with a similar configuration is shown in EP 0 573 372 A2.

US 4,712,064 A discloses a magnetoresistive sensor used for emitting of electric signals in dependency on the position of the speed of a ferromagnetic body. The magnetoresistive sensor comprises a plurality of measuring strips that are mounted on a substrate. The substrate is stationary mounted with a superimposed permanent magnet. The measuring strips are connected with each other to a bridge circuit with four resistors.

US 5,351,028 A discloses a magnetoresistive proximity sensor comprising planar magnetoresistive elements which are arranged in a bridge configuration. The planar magnetoresistive elements lie in a plane of a radial magnetic field. The proximity sensor detects the approach of a ferromagnetic object by detecting movement of the effective center of the radial magnetic field.

DE 199 19 681 Al discloses a method and a device for determining the strength and/or the direction of a particular magnetic field. This is achieved by exposing a magnetoresistive sensor to a first magnetic field and second magnetic compensatory field.

US 2003/0151406 Al and US 5,686,837 A both disclose magnetic field sensing devices that utilize magnetoresistive elements which are arranged in a bridge on a substrate. These magnetoresistive elements are placed in a common plane. On a second plane above this plane are arranged current conductors that create auxiliary fields. These auxiliary magnetic fields may be used to compensate a small field offset.

US 5,719,494 A discloses a sensor assembly for measuring a current. The sensor assembly comprises four magnetoresistive elements arranged to form a Wheatstone bridge disposed over a U shaped conductor.

US 2003/0141957 Al discloses two sensor units that are formed from magnetoresistive material. Each unit consists of mangetoresistive elements made of magnetoresistive material that are arranged as a Wheatstone bridge. The arrangement further comprises an integral coil that sets a direction of magnetization in the elements of the first and the second sensor units.

It is an object of the invention to provide a simple sensor arrangement for measuring a medium that affects a magnetic field.

According to the invention, this object is achieved by a magnetic-field-sensitive sensor arrangement according to claim 1.

By means of such a sensor arrangement, the content of a particular substance of known magnetic permeability in the medium surrounding the sensor arrangement can easily be determined from the measurement signal in that the value of the latter is placed in relation with a value determined for a medium of known composition. In particular, liquid or gaseous media can be measured in this way by means of the sensor arrangement according to the invention. Preferably, the oxygen concentration in such a medium can be determined.

The design of the sensor arrangement according to the invention with at least one magnetic-field-sensitive semiconductor element allows simple, compact and extremely cost-effective manufacture. The stability with respect to mechanical and thermal stresses is extremely high. Compared to conventional large-volume sensor arrangements with a space requirement of about 1 to 20 liters, a great miniaturization effect is achieved. By virtue of the invention, a sensor arrangement is provided which is small, light, inexpensive and very versatile in its use. Besides a use in the fields of chemistry, physics or biology laboratory technology, sports, medicine or respiratory protection in the widest sense, the sensor arrangement according to the invention can also be used in the field of consumer technology, in particular motor vehicle technology. This includes in particular measuring the oxygen supply to internal combustion engines and also the oxygen content in exhaust gases for the preferred fields of use.

The magnetoresistive-field-sensitive sensor arrangement according to the invention utilizes at least one magnetoresistive element. Despite the higher values of the measurement signal that can thus be achieved and the higher interference immunity thus provided, the magnetoresistive elements used are preferably those which use the so-called TMR effect or the so-called GMR effect as magnetoresistive effect. It is also possible to use magnetoresistive elements which use the so-called AMR effect as magnetoresistive effect, wherein lower values are set for the measurement signal on account of the physical properties of said magnetoresistive elements. Depending on the magnetoresistive effect used and possibly also on further materials used for manufacture, for example housing materials, sensor arrangements designed in this way can be used in a wide temperature range. For example, a temperature range of -65°C to 500°C is possible. Elements which use the Hall effect can in principle also be used.

The magnetic field is formed with a stabilizing magnet. This is preferably designed as a permanent magnet, whereby a particularly simple, robust and cost-effective design of the sensor arrangement according to the invention is possible. If, on the other hand, a magnetic field with an adjustable field strength is desired, the device which forms the magnetic field may also be designed with coils, to which a current is fed in order to generate the magnetic field.

Further, the magnetic-field-sensitive sensor arrangement according to the invention has at least a second conductor arrangement for generating at least a first additional magnetic field component in the measurement direction of the sensor arrangement. This first additional magnetic field component can be superposed on the measurement field and can be used to compensate certain parts or the entire measurement field. The second conductor arrangement is therefore also referred to as the compensation conductor. In order to form the first additional magnetic field component, the second conductor arrangement is acted upon by a current which is also referred to as the compensation current.

The magnetic-field-sensitive sensor arrangement according to the invention is further characterized by at least a third conductor arrangement for generating at least a second additional magnetic field component in a direction which is at least largely at right angles to the measurement direction of the sensor arrangement. In particular, controlled reversal of the characteristic of the sensor arrangement, that is to say the function of the value of the measurement signal as a function of the magnetic field strength of the measurement field, can thus be achieved. This reversal, known as "flipping", takes place in the zero crossing of the field strength of the component of the magnetic field at right angles to the direction of the measurement field. The third conductor arrangement is therefore also referred to as the "flip conductor" and the current flowing through it to generate the at least a second additional magnetic field component is referred to as the "flip current". By means of this "flipping" of the characteristic, it is advantageously possible to determine an offset in it. In this way, the at least a second additional magnetic field component can be used to set an operating point of the sensor arrangement and is preferably provided for this purpose.

According to a further development of the invention, the stabilizing magnet has a recess on one of its surfaces, via or in which recess the first conductor arrangement is arranged. Such recesses per se have already been described as crater-like depressions in German patent application 101 41 371.8. Said document furthermore states that the crater-like depressions are formed by flat surfaces or concave surfaces running toward the positioning plane. By virtue of such a design, in the sensor device described in said document it is achieved, in a simple manner, that magnetic fields lying in the positioning region of the sensor element can be minimized in a particularly optimal manner. A course of the magnetic field lines designed in this way is also referred to as "divergence-free". A trench-like or pot-shaped recess is particularly advantageous for generating a divergence-free field.

According to a further development of the magnetic-field-sensitive sensor arrangement according to the invention, the stabilizing magnet is magnetized such that the field lines of the magnetic field formed by it emerge essentially vertically from a bottom surface of the recess. In this way it is advantageously possible to achieve a magnetic field at the location of the first conductor arrangement which is at least virtually divergence-free even when the conductor arrangement is surrounded by a medium the relative magnetic permeability of which assumes at least almost the value 1. The value of the magnetic field strength of the measurement field at the location of the first conductor arrangement is in this case at least almost zero. On the other hand, by virtue of this design of the surface of the stabilizing magnet of the field line course it is achieved that the value of the magnetic field strength of the measurement field increases as the value of the relative magnetic permeability of the medium surrounding the first conductor arrangement increases. As a result, it is achieved in a simple manner that the value of the measurement signal is a measure of the magnetic permeability of the medium and hence of the composition of the latter.

Preferably, the at least a first additional magnetic field component is provided to superpose and/or compensate a magnetic field externally impressed on the sensor arrangement in the measurement direction. This is because if the compensation current is set for measurement purposes such that the entire measurement field is compensated, the value of the compensation current can also be evaluated as a measurement signal over the course of such a compensation measurement. On the other hand, the compensation current may also be selected such that the effect of interference fields or undesirable shifts in the value of the measurement signal - known as offsets - are compensated.

In another refinement of the invention, the magnetic-field-sensitive sensor arrangement is characterized by an evaluation circuit to which the measurement signal of the sensor arrangement is fed, and also a temperature measurement device which is coupled to the evaluation circuit and in which a temperature signal is generated that is a measure of the current temperature of the sensor arrangement and/or of the medium surrounding the latter, wherein the temperature signal is likewise fed to the evaluation circuit in order to compensate a temperature-induced change in the measurement signal of the sensor arrangement. The temperature measurement device is formed for example by an additional sensor which is externally added to the conductor arrangements or to the evaluation circuit, but may also be formed by a sensor device accommodated internally within the evaluation circuit. By using such a temperature measurement device, the effect of temperature fluctuations on the measurement signal can advantageously be eliminated from the latter and thus the influencing variables of temperature and magnetic permeability are distinguished from one another.

In particular, the compensation of the temperature-induced change in the measurement signal of the sensor arrangement in the evaluation circuit advantageously also comprises the compensation of a temperature-dependence of the device which forms the measurement field. In this way, not only is compensation of the temperature profile of the first conductor arrangement achieved, but also of the stabilizing magnet, for example the remanence induction of the material of which this stabilizing magnet is made.

Advantageously, according to a first variation the compensation of temperature-induced changes in the measurement signal of the sensor arrangement in the evaluation circuit is effected by converting the values of the measurement signal according to a predefined function of the temperature. This is carried out in particular by mathematical compensation during the further signal processing of the measurement signal in an arithmetic unit contained in the evaluation circuit. In a second variation, at least a fourth conductor arrangement which is coupled to the evaluation circuit and is fed by the latter according to a predefined function of the temperature is provided for impressing at least a third additional magnetic field component for compensating temperature-induced changes in the measurement signal of the sensor arrangement. Such a temperature compensation can preferably be carried out with field-generating coils that are connected to the device which forms the measurement field with a value of its magnetic field strength, that is to say in particular also to the stabilizing magnet. Said coils are actuated by the evaluation circuit and the temperature measurement device coupled thereto.

According to another development, the magnetic-field-sensitive sensor arrangement is characterized by at least a fifth conductor arrangement which comprises at least one electrical half-bridge with at least two bridge branches that are insensitive to magnetic fields, which fifth conductor arrangement is connected to the first conductor arrangement or parts thereof in a predefined operating state of the sensor arrangement to form a bridge circuit. This fifth conductor arrangement is provided to supply a reference signal which is independent of the magnetic fields, and is also referred to as the "reference half-bridge".

In one development, the fifth conductor arrangement is combined with at least the first conductor arrangement to form a common module. In this case, the "reference half-bridge" is integrated with the conductor arrangement which is also referred to as the "sensor bridge". This tight connection ensures operating parameters that are as greatly matched as possible between the reference half-bridge and the sensor bridge, in particular temperatures that at least largely coincide.

In another development, the fifth conductor arrangement is combined with at least the evaluation circuit to form a common module. By means of such an integration of the reference half-bridge with the evaluation circuit, as great a matching as possible in particular of the manufacturing tolerances and operating temperature is achieved between these modules.

In another refinement of the magnetic-field-sensitive sensor arrangement according to the invention, the medium surrounding the sensor arrangement surrounds the first conductor arrangement only in the region of part of its half-bridges, and the rest of the sensor arrangement is surrounded by a material which suppresses the effect of the magnetic permeability of the medium on at least one of the half-bridges of the first conductor arrangement. Preferably, the at least one magnetic-field-sensitive semiconductor element of a first of the half-bridges is surrounded by the medium the magnetic permeability and hence the composition of which is to be measured, and the at least one magnetic-field-sensitive semiconductor element of a second of the half-bridges is surrounded by the material which suppresses the effect of the magnetic permeability of the medium on the at least one magnetic-field-sensitive semiconductor element. This material may be magnetically conductive or magnetically non-conductive. In particular, its magnetic permeability is selected to be matched to the design of the device which forms the measurement field with a value of its magnetic field strength, preferably the stabilizing magnet, such that a divergence-free magnetic field is produced around the second half-bridge.

The second and third conductor arrangements may preferably have individual sections which are assigned in spatial and functional terms to the individual half-bridges of the first conductor arrangement, that is to say they are arranged close to said half-bridges and preferably act on them during operation. These sections of the second and third conductor arrangements are then preferably surrounded in a corresponding manner by the medium that is to be measured or by the material that suppresses the effect of the magnetic permeability of the medium that is to be measured.

The magnetic-field-sensitive sensor arrangement according to the invention can advantageously be used to measure in particular gaseous or liquid media. It is preferably characterized by a design for a medium with variable oxygen content. In this way it can be particularly advantageously used as an oxygen sensor. Such an oxygen sensor is at least largely insensitive to
- a measurement signal other than zero in an oxygen-free medium, that is to say an offset in the measurement signal,
- temperature- and aging-induced changes in the offset, the measurement sensitivity and the magnetic field strength of the measurement field, and
- external magnetic interference fields.

The magnetic-field-sensitive sensor arrangement according to the invention is thus particularly suitable for use in the motor vehicle technology sector.

The invention will be further described with reference to examples of embodiments shown in the drawing to which, however, the invention is not restricted.
Fig. 1 schematically shows a plan view of a first example of embodiment of a magnetic-field-sensitive sensor arrangement according to the invention.
Fig. 2 schematically shows a plan view of the conductor arrangements of the first example of embodiment of the magnetic-field-sensitive sensor arrangement according to the invention as shown in Fig. 1.
Fig. 3 schematically shows a section through the sensor arrangement of Fig. 1 in a plane which runs along the y-axis perpendicular to the plane of the drawing of Fig. 1, with the form of a magnetic field in a first operating state.
Fig. 4 shows a diagram in which an example of the magnetic field strength of the measurement field in the direction of the y-axis is plotted as a function of the distance from the coordinate zero point for the first operating state shown in Fig. 3.
Fig. 5 schematically shows a section through the sensor arrangement of Fig. 1 in a plane which runs along the y-axis perpendicular to the plane of the drawing of Fig. 1, with the form of a magnetic field in a second operating state.
Fig. 6 shows a diagram in which an example of the magnetic field strength of the measurement field in the direction of the y-axis is plotted as a function of the distance from the coordinate zero point for the second operating state shown in Fig. 5.
Fig. 7 shows a diagram with a schematic representation of a characteristic of a magnetoresistive sensor with an offset and a flipping of the characteristic profile controlled by applying a second additional magnetic field component in the direction of the x-axis, wherein the value of the measurement signal is plotted against the value of the magnetic field strength of the measurement field.
Fig. 8 shows a diagram with a schematic representation of the temperature-dependence of a characteristic of a magnetoresistive sensor as shown in Fig. 7.
Fig. 9 schematically shows a plan view of a second example of embodiment of a magnetic-field-sensitive sensor arrangement according to the invention.
Fig. 10 schematically shows a plan view of the conductor arrangements of the second example of embodiment of the magnetic-field-sensitive sensor arrangement according to the invention as shown in Fig. 9.
Fig. 11 is a diagram showing an example of the dependence of the magnetic field strength of the measurement field on the relative magnetic permeability.
Fig. 12 shows a first example of the design of a stabilizing magnet for use in a magnetic-field-sensitive sensor arrangement according to the invention.
Fig. 13 shows a second example of the design of a stabilizing magnet for use in a magnetic-field-sensitive sensor arrangement according to the invention.
Fig. 14 shows a third example of the design of a stabilizing magnet for use in a magnetic-field-sensitive sensor arrangement according to the invention.

In the drawings, elements which coincide are provided with identical references.

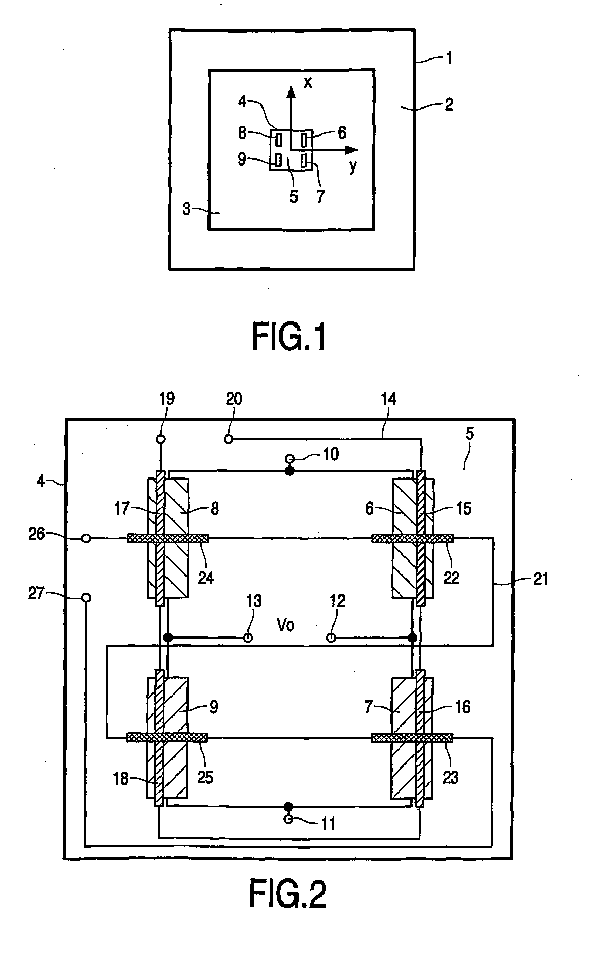

Fig. 1 schematically shows the plan view of a stabilizing magnet 1 with a square outline, which is designed with a centrally aligned recess 3 on its surface 2, a plate-like semiconductor substrate 4 being arranged plane-parallel to the surface 2 in the center of said recess. The semiconductor substrate 4 has on its surface 5 remote from the stabilizing magnet 1 a first conductor arrangement which is shown by the schematic representation of four magnetic-field-sensitive semiconductor elements 6, 7, 8 and 9. In this example of embodiment, the semiconductor elements 6, 7, 8 and 9 are designed as magnetoresistive resistor elements. Each of the semiconductor elements 6, 7, 8 and 9 is a bridge branch of the first conductor arrangement, wherein a first and a second of the semiconductor elements bearing references 6 and 7 form a first of two electrical half-bridges and a third and a fourth of the semiconductor elements bearing references 8 and 9 form the second of these half-bridges. A Cartesian coordinate system in the surface 5 of the semiconductor substrate 4 points with its y-axis in the measurement direction of the sensor arrangement and with its x-axis at right angles thereto. The x-axis thus denotes the coordinate direction of the sensor arrangement which is also referred to as the insensitive direction and runs perpendicular to the so-called "hard axis" of the magnetoresistive resistor elements. The y-axis thus denotes the coordinate direction of the sensor arrangement which is also referred to as the sensitive direction and runs perpendicular to the so-called "easy axis" of the magnetoresistive resistor elements. The magnetoresistive resistor elements extend over the surface 5 of the semiconductor substrate 4, that is to say in the x-y plane of the aforementioned Cartesian coordinate system.

Fig. 2 shows a detailed schematic diagram of the semiconductor substrate 4 of the first example of embodiment of the magnetic-field-sensitive sensor arrangement according to the invention as shown in Fig. 1. The semiconductor elements 6, 7, 8 and 9 are electrically connected to one another to form two half-bridges which are arranged between a first and a second supply voltage terminal 10 and 11. The semiconductor elements 6, 7 and 8, 9 of the two half-bridges are connected to one another in each case via a connecting point 12 and 13, respectively, which in each case forms a tap for tapping off the measurement signal, denoted Vo. One of the two supply voltage terminals, for example the second one 11, may be led to ground potential.

The semiconductor elements 6, 7, 8 and 9 are shown in the diagram of Fig. 2 by hatched areas, the slope of which hatching symbolizes the alignment of the so-called barber pole structures when the semiconductor elements 6, 7, 8 and 9 are designed as so-called AMR elements (this abbreviation in this case stands for "anisotropic magnetoresistive"). If, on the other hand, the semiconductor elements 6, 7, 8 and 9 are designed as so-called GMR elements (this abbreviation in this case stands for "giant anisotropic magnetoresistive"), the slope of the hatching in the representation of the semiconductor elements 6, 7, 8 and 9 symbolizes the setting of the so-called internal "bias direction" of the GMR elements.

Besides the first conductor arrangement comprising the semiconductor elements 6, 7, 8 and 9, a second conductor arrangement 14 is arranged on the surface 5 of the semiconductor substrate 4, said second conductor arrangement also being referred to as the compensation conductor. This comprises, for each of the four semiconductor elements 6, 7, 8 and 9, in each case a conductor strip 15, 16, 17, 18 which is applied to said conductor element and is electrically isolated therefrom. All the conductor strips 15, 16, 17, 18 of the compensation conductor 14 are connected to one another in series as shown. At its ends, the compensation conductor 14 is connected to terminals 19 and 20. If a current, also referred to as the compensation current, is impressed on the compensation conductor 14, each of the conductor strips 15, 16, 17, 18 at the location of the associated semiconductor element 6, 7, 8 and 9 generates a magnetic field component in the measurement direction, that is to say in the direction of the y-axis, which is superposed on the measurement field and by means of which an external magnetic field - in particular an interference field, but possibly also the measurement field depending on the mode of operation of the sensor arrangement - can be compensated. In this case, the series connection of the conductor strips 15, 16, 17, 18 is designed such that the magnetic field component generated by the first and second conductor strips 15 and 16 is directed in the opposite direction to that of the magnetic field component generated by the third and fourth conductor strips 17 and 18.

Finally, in the example of embodiment shown in Fig. 2, a third conductor arrangement 21 is applied above the first and second conductor arrangements 6, 7, 8, 9 and 14, said third conductor arrangement likewise being electrically isolated from the two other conductor arrangements. This third conductor arrangement 21, which is also referred to as the flip conductor, likewise comprises, for each of the four semiconductor elements 6, 7, 8 and 9, in each case a conductor strip 22, 23, 24 and 25 which is applied to said conductor elements and is electrically isolated from the latter and also from the conductor strips 15, 16, 17, 18 of the compensation conductor 14. However, the conductor strips 22, 23, 24 and 25 of the flip conductor 21 are arranged at right angles to the conductor strips 15, 16, 17, 18 of the compensation conductor 14, since they are to generate, when acted upon by a current, the so-called flip current, a second additional magnetic field component in the insensitive direction x which is at right angles to the measurement direction y of the sensor arrangement. This second additional magnetic field component is used for the controlled flipping of the characteristic of the sensor arrangement when the semiconductor elements 6, 7, 8 and 9 are designed as AMR elements or for setting the internal bias direction when the semiconductor elements 6, 7, 8 and 9 are designed as GMR elements. All the conductor strips 22, 23, 24 and 25 of the flip conductor 21 are also connected to one another in series. At its ends, the flip conductor 21 is connected to terminals 26 and 27. In this case, the series connection of the conductor strips 22, 23, 24 and 25 is designed such that all the magnetic field components generated by them are aligned in the same way in the direction of the x-axis.

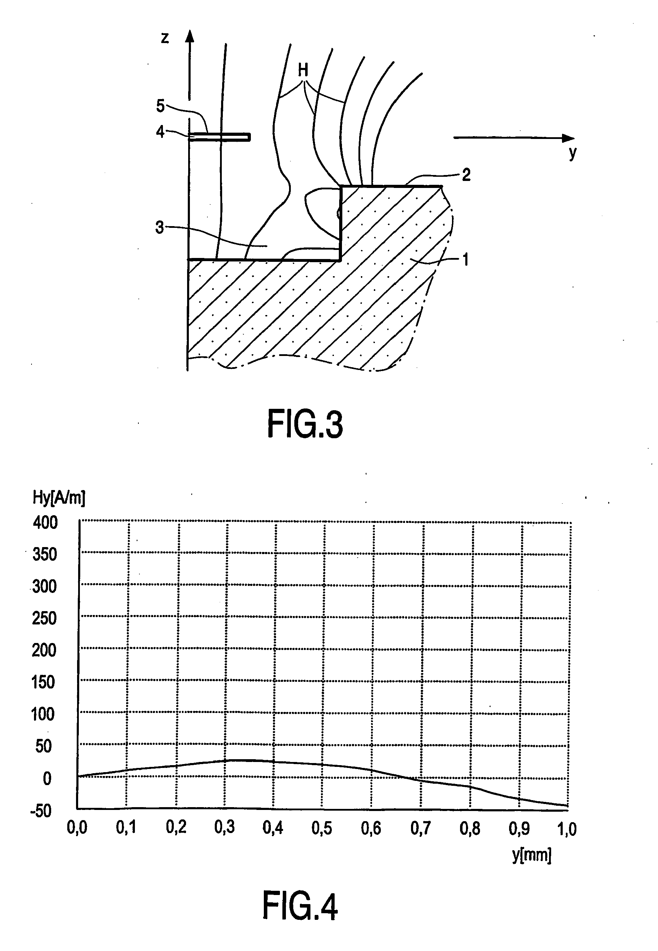

Fig. 3 shows a schematic diagram of a section through the stabilizing magnet 1 and the semiconductor substrate 4 of the sensor arrangement of Fig. 1 in a plane which runs along the y-axis perpendicular to the plane of the drawing of Fig. 1, with the form of a magnetic field in a first operating state in which the relative magnetic permeability µrel of a medium which surrounds the sensor arrangement, and therein in particular the semiconductor substrate 4 and the surface 2 of the stabilizing magnet 1 in the region of the recess 3, assumes the value 1. This corresponds to the operating state in an oxygen-free medium. The field lines of the magnetic field H formed by the stabilizing magnet 1 in this operating state then run, in the region of the semiconductor substrate 4 and thus the first conductor arrangement located thereon with the semiconductor elements 6, 7, 8, 9, at least virtually exclusively at right angles to a plane formed by the x- and y-axis, in a direction referred to as the z-axis. The magnetic field H at the location of the first conductor arrangement with the semiconductor elements 6, 7, 8, 9 is thus at least virtually divergence-free, and the magnetic field strength Hy of the measurement field is at least virtually zero.

In Fig. 4, the profile of the magnetic field strength Hy of the measurement field is plotted against the y coordinate using numerical values given by way of example.

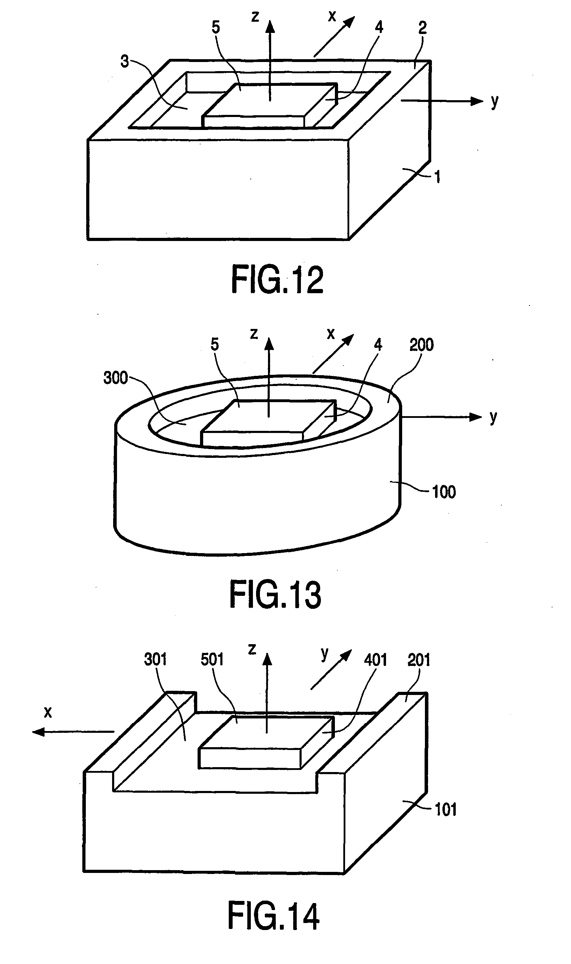

In the example of embodiment of the sensor arrangement shown in Fig. 1, use is preferably made of a stabilizing magnet 1 as shown separately in Fig. 12. The stabilizing magnet 1 shown in Fig. 12 is of a square shape. Provided on its square surface 2 is a recess 3 which is likewise of square shape. Arranged in this recess 3 is a semiconductor substrate 4, the surface 5 of which that is remote from the stabilizing magnet 1 in this case lies in the plane of the surface 2 of the stabilizing magnet 1. Furthermore arranged in this plane is the Cartesian coordinate system consisting of x-axis and y-axis, wherein the axes run at right angles to the edge sides of the surface 2 of the stabilizing magnet 1, said edge sides intersecting said axes. The coordinate direction running at right angles to the plane formed by the x- and y-axes is formed by a z-axis which in the example shown passes through the center of the surface 2, the recess 3 and the semiconductor 4, so that the edges of the recess are formed with the same width on all sides in both coordinate directions x and y. The stabilizing magnet 1 is furthermore magnetized such that, for the case where the relative magnetic permeability constant µrel assumes the value 1, a magnetic field which is at least largely divergence-free both in the direction of the x-axis and in the direction of the y-axis is formed at least in the direct vicinity of the z-axis enclosed by the semiconductor substrate 4. As an example of the size, such a stabilizing magnet 1 may have external dimensions of 8 mm × 8 mm × 4.5 mm.

In Fig. 13, reference 100 separately shows a variation of the stabilizing magnet 1 shown in Fig. 12, this magnet having a circular shape. Provided on its circular surface 200 is a recess 300 which is likewise of circular shape. Arranged in this recess 300 is the semiconductor substrate 4, the surface 5 of which that is remote from the stabilizing magnet 100 in this case lies in the plane of the surface 200 of the stabilizing magnet 100. Furthermore arranged in this plane is the Cartesian coordinate system consisting of x-axis and y-axis, wherein the axes run at right angles to the edge sides of the semiconductor substrate 4, said edge sides intersecting said axes. The coordinate direction running at right angles to the plane formed by the x- and y-axes is formed in this case too by a z-axis which in the example shown passes through the center of the surface 200, the recess 300 and the semiconductor substrate 4, so that the z-axis coincides with the axis of rotation of the circular shape of the stabilizing magnet 100. The edge of the recess 300 is formed with the same width in all directions of the plane formed by the x- and y-axes. The stabilizing magnet 100 is furthermore magnetized such that, for the case where the relative magnetic permeability constant µrel assumes the value 1, a magnetic field which is at least largely divergence-free in all directions of the plane formed by the x- and y-axes is formed at least in the direct vicinity of the z-axis enclosed by the semiconductor substrate 4.

If the sensor arrangement shown in Fig. 1 is exposed, starting from the operating state shown in Figs. 3 and 4, to a medium with a higher value of the relative magnetic permeability constant µrel, for example to an oxygen-containing gaseous medium, the profile of the magnetic field H shown in Fig. 3 deforms such that it becomes more and more divergent in the region of the semiconductor substrate 4 in the direction of the x-axis and the y-axis. The magnetic field H, which passes through the first conductor arrangement 6 arranged on the semiconductor substrate 4, thus has a component of this magnetic field H in the sensitive direction of the sensor arrangement which increases as the value of the relative magnetic permeability constant µrel increases: the magnetic field strength Hy of the measurement field increases. As a result, a measurement signal Vo is generated in the sensor arrangement, the value of which measurement signal is directly proportional to the magnetic field strength Hy of the measurement field. The value of the measurement signal Vo is thus directly proportional to the oxygen content of the medium surrounding the sensor arrangement.

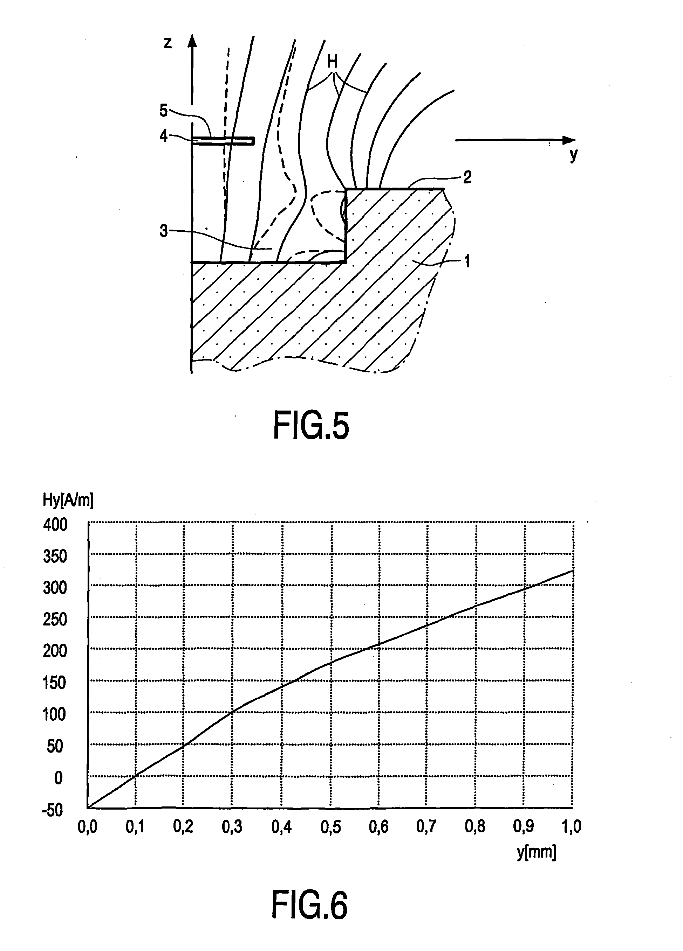

Fig. 5 shows, for an operating state in which the oxygen content of the medium surrounding the sensor arrangement is 100%, a schematic diagram of a section through the stabilizing magnet 1 and the semiconductor substrate 4 of the sensor arrangement of Fig. 1 in a plane which runs along the y-axis perpendicular to the plane of the drawing of Fig. 1, with the form of the magnetic field H in this operating state in which the relative magnetic permeability µrel of the medium which surrounds the sensor arrangement, and therein in particular the semiconductor substrate 4 and the surface 2 of the stabilizing magnet 1 in the region of the recess 3, assumes the value 1.15. This corresponds to the operating state in a medium consisting of pure oxygen. For comparison purposes, some of the field line profiles from the operating state of Fig. 3 are shown in dashed line in Fig. 5.

Fig. 6 shows a diagram, comparable to Fig. 4, of the magnetic field strength Hy of the measurement field as a function of the y coordinate for the operating state shown in Fig. 5, with exemplary numerical values and a clearly visible rise in the magnetic field strength Hy of the measurement field as a function of the y coordinate.

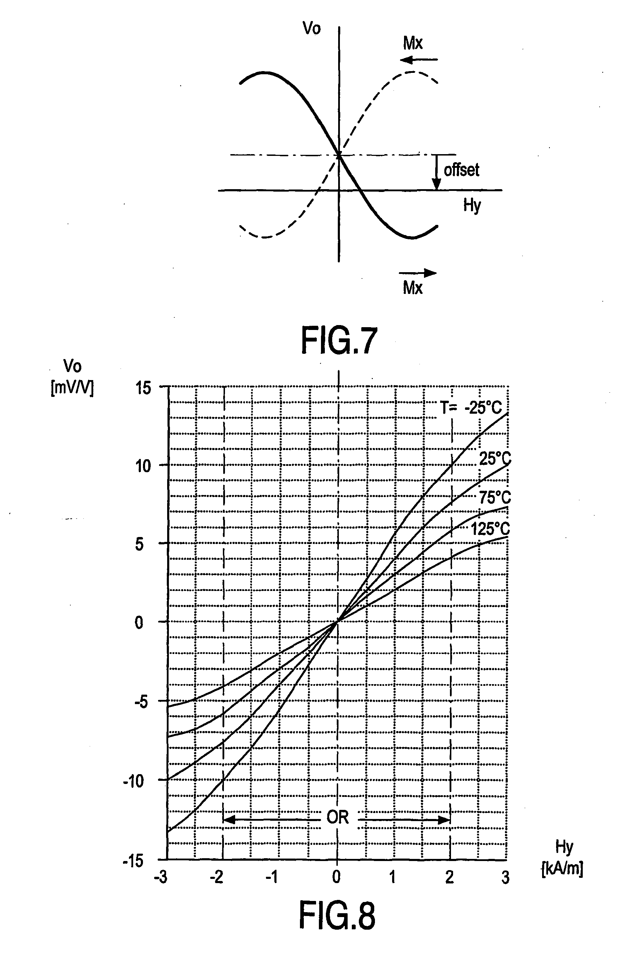

Fig. 7 shows a diagram with a schematic representation of a characteristic of the magnetoresistive sensor arrangement shown in Fig. 1, 2, 3 or 5. Therein, the value of the measurement signal Vo is plotted against the value of the magnetic field strength Hy of the measurement field. The measurement signal Vo describes an essentially sinusoidal curve as a function of the magnetic field strength Hy of the measurement field, which curve has a zero offset which is denoted "offset" and the orientation of which depends on the direction of the magnetic field in the insensitive direction, that is to say the x-axis. In Fig. 7, two characteristic profiles for two directions of the magnetic field in the direction of the x-axis are shown by way of example: the characteristic profile shown in unbroken line is for a magnetic field oriented in one direction whereas the characteristic profile shown in dashed line is obtained when this orientation is reversed. This is symbolized by the arrows on the characteristics and the reference Mx.

By reversing the direction of the magnetic field acting on the sensor arrangement along the x coordinate, the characteristic profile can be flipped. This flipping of the characteristic takes place in the zero crossing of the field strength of the component of the magnetic field in the x direction and is brought about in the sensor arrangement shown by way of example by a current, the flip current, which flows through the flip conductor 21 and thus generates a second additional magnetic field component. The second additional magnetic field component in the direction of the x-axis is superposed on the magnetic field of the stabilizing magnet 1 and thus controls the flipping of the characteristic profile.

With the aid of this flipping of the characteristic, an offset in the latter can advantageously be determined. For this purpose, the flip current is fed into the flip conductor 21 in a pulsed manner, in order that an operating point of the sensor arrangement can be set and the characteristic profile obtained therefor can be determined. The zero offset, denoted "offset", is determined from the point of intersection of the resulting characteristic profiles.

During operation of the sensor arrangement, a stable operating point is set by the flip current, which is now kept constant, and thus the second additional magnetic field component in the direction of the x-axis following determination of the zero offset. In the event of further flowing flip current and thus a stable operating point of the sensor arrangement, a compensation current is then fed into the compensation conductor 14 and the value thereof is set such that the value of the measurement signal Vo is equal to the previously determined value of the zero offset. The value of the compensation current which then flows is a measure of the relative magnetic permeability µrel of the medium which surrounds the sensor arrangement, and thus of the oxygen content thereof.

In this design of the magnetic circuit, an effective component Hy of the magnetic field strength in the y direction is obtained only when the magnetic permeability of the medium which surrounds the sensor arrangement changes. This component Hy of the magnetic field strength in the y direction has the same relative temperature coefficient as the remanence of the stabilizing magnet 1, that is to say the magnetic field strength or magnetic induction of the magnetic field H formed by the stabilizing magnet 1. The value of the measurement signal Vo, which is obtained in the manner described, is thus still dependent on the temperature and must be temperature-compensated using an additional temperature sensor which is not shown in the drawing. This preferably takes place in an evaluation circuit, which is connected to the first conductor arrangement 6, 7, 8, 9 via the first and second connecting points 12, 13 and is fed the measurement signal Vo of the sensor arrangement. Also connected to this evaluation circuit is the temperature sensor in which a temperature signal is generated which is a measure of the current temperature of the sensor arrangement. The temperature signal is likewise fed to the evaluation circuit in order to compensate the temperature-induced change in the measurement signal Vo of the sensor arrangement.

Fig. 8 shows an example of a diagram with a schematic representation of the temperature-dependence of a characteristic Vo over Hy of a magnetoresistive sensor arrangement. Characteristic examples for the four values -25°C, 25°C, 75°C and 125°C of the temperature, denoted T, of the sensor arrangement, that is to say of the semiconductor substrate 4 with the elements arranged thereon, are plotted. The operating range in which this characteristic is used in the described example is denoted OR and in this case is about 4 kA/m. When using the above-described compensating measurement, in which a compensation current is fed into the compensation conductor 14 and the value thereof is set such that the value of the measurement signal Vo is equal to the previously determined value of the zero offset, only a very small range around the zero point is used by the characteristics shown in Fig. 8. The temperature coefficient of the sensitivity of the sensor can thus then be disregarded.

The above-described sensor arrangement forms an integrated paramagnetic oxygen sensor. In this case, homogeneous magnetic interference fields are suppressed by a gradiometric design of the magnetic-field-sensitive semiconductor elements combined in the first conductor arrangement, that is to say by an arrangement of these semiconductor elements in the configuration of a gradient sensor. Compensation of the zero offset including the temperature effect thereof is made possible by flipping the characteristic. The effect of temperature on the measurement sensitivity of the first conductor arrangement is also kept small, such that it can be disregarded, by using the compensation principle where a compensation current is used during the measurement.

The effect of temperature on the remanence of the stabilizing magnet can be suppressed on the one hand in the described manner by an additional temperature measurement and compensation of the temperature coefficient of the remanence by means of an evaluation circuit. For this purpose, the evaluation circuit must be fed data about the temperature coefficient of the remanence or have such data stored within it. On the other hand, compensation of the temperature coefficient of the remanence may be carried out by field-generating coils which are additionally arranged in the region of the stabilizing magnet, which coils were referred to in the introduction as the fourth conductor arrangement. Said coils are likewise actuated as a function of a temperature measured on the sensor arrangement and the temperature coefficient of the remanence and compensate temperature-induced fluctuations in the remanence.

During operation of the sensor arrangement, a simultaneous fluctuation both of the oxygen content of the medium and of the temperature can be distinguished from one another only with the aid of the additional temperature measurement described above. If a temperature measurement is to be omitted in order to reduce the outlay on apparatus, these simultaneous fluctuations must be ruled out.

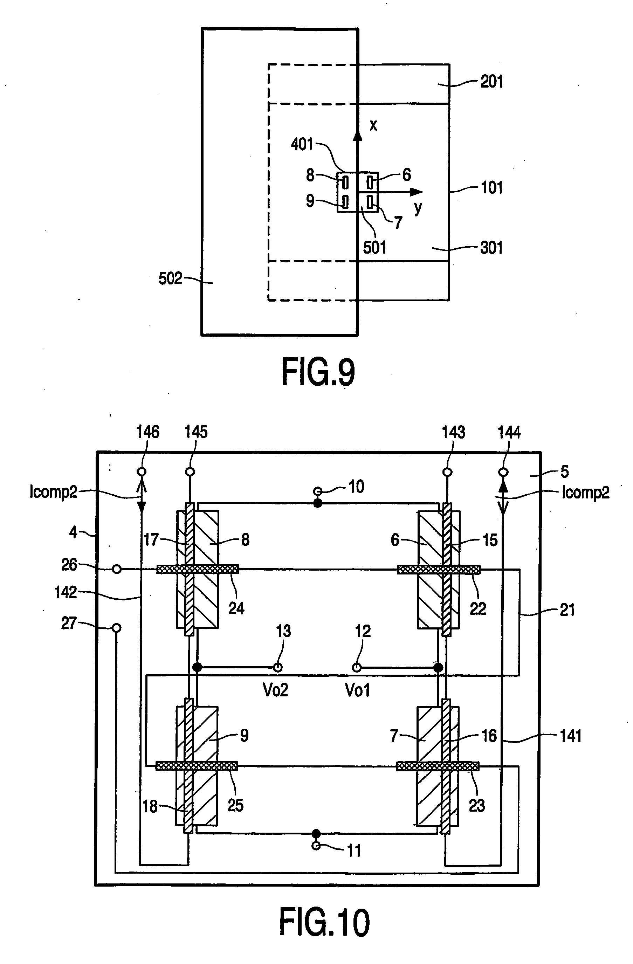

Fig. 9 schematically shows, in a plan view, a further example of embodiment of a magnetic-field-sensitive sensor arrangement according to the invention. For the sensor arrangement shown here, a square stabilizing magnet 301 is used which is designed with a recess 301 aligned centrally in the x-axis on its surface 201, a plate-like semiconductor substrate 401 being arranged plane-parallel to the surface 201 in the center of said recess. The semiconductor substrate 401 has on its surface 501 remote from the stabilizing magnet 101 a first conductor arrangement which is shown by the schematic representation of four magnetic-field-sensitive semiconductor elements 6, 7, 8 and 9 and is identical to that of Figs. 1 and 2. A Cartesian coordinate system in the surface 501 of the semiconductor substrate 401 points with its y-axis in the measurement direction of the sensor arrangement and with its x-axis at right angles thereto. The x-axis thus denotes the coordinate direction of the sensor arrangement which is also referred to as the insensitive direction and runs perpendicular to the so-called "hard axis" of the magnetoresistive resistor elements. The y-axis thus denotes the coordinate direction of the sensor arrangement which is also referred to as the sensitive direction and runs perpendicular to the so-called "easy axis" of the magnetoresistive resistor elements. The magnetoresistive resistor elements extend over the surface 501 of the semiconductor substrate 401, that is to say in the x-y plane of the aforementioned Cartesian coordinate system.

Compared to the arrangement shown in Fig. 1, two modifications are shown in Fig. 9. On the one hand, the recess 301 on the surface 201 of the stabilizing magnet 101 extends in the y direction, that is to say in the sensitive direction of the sensor arrangement, over the entire extent of the stabilizing magnet 101. In this way, a magnetic field that is at least virtually divergence-free only in the x direction is obtained at the location of the semiconductor substrate 401, whereas the magnetic field in the sensitive y direction is divergent at the location of the semiconductor substrate 401. On the other hand, half the sensor arrangement, that is to say of the stabilizing magnet 101 and of the semiconductor substrate 401, is provided with a cover 502, the edge of which runs along the x-axis centrally above the stabilizing magnet 101 and the semiconductor substrate 401. The cover 502 is made of a material which suppresses an effect of the magnetic permeability of the medium that is to be measured on the second half-bridge of the first conductor arrangement 6, 7, 8, 9, said second half-bridge being formed from the third and fourth semiconductor elements 8, 9, and preferably completely encapsulates said second half-bridge. The medium that is to be measured and surrounds the rest of the sensor arrangement surrounds the first conductor arrangement 6, 7, 8, 9 only in the region of its first half-bridge formed from the first and second semiconductor elements 6, 7. The material of the cover 502 may be magnetically conductive or magnetically non-conductive; its magnetic permeability is preferably constant. In particular, this magnetic permeability may be selected to be matched to the design of the stabilizing magnet 101 such that an at least largely divergence-free magnetic field is generated around the second half-bridge 8, 9.

Fig. 10 shows a more detailed schematic diagram of the semiconductor substrate 401 of the second example of embodiment of the magnetic-field-sensitive sensor arrangement according to the invention as shown in Fig. 9. The first conductor arrangement comprising the semiconductor elements 6, 7, 8 and 9 corresponds to that of the arrangement shown in Fig. 2, although the measurement signals can now be evaluated separately at the first and second connecting points 12, 13 of the individual half-bridges 6, 7 and 8, 9 and are therefore provided with distinct references Vo1 and Vo2. This is achieved by appropriate connections to an evaluation circuit (not shown).

Besides the first conductor arrangement, a second conductor arrangement is arranged on the surface 501 of the semiconductor substrate 401. Said second conductor arrangement comprises, for each of the four semiconductor elements 6, 7, 8 and 9, in each case a conductor strip 15, 16, 17, 18 which is applied to said conductor element and is electrically isolated therefrom. The first 15 and second 16 of these conductor strips are connected to one another in series as shown and form a first compensation conductor 141. At its ends, the first compensation conductor 141 is connected to terminals 143 and 144. The third 17 and fourth 18 of the conductor strips of the second conductor arrangement are likewise connected to one another in series and form a second compensation conductor 142. At its ends, the second compensation conductor 142 is connected to terminals 145 and 146. If currents, also referred to as the first and second compensation currents Icomp1 and Icomp2, are impressed on the compensation conductors 141, 142, each of the conductor strips 15, 16, 17, 18 at the location of the associated semiconductor element 6, 7, 8 and 9 generates a magnetic field component in the measurement direction, that is to say in the direction of the y-axis, which is superposed on the measurement field and by means of which an external magnetic field - in particular an interference field, but possibly also the measurement field depending on the mode of operation of the sensor arrangement - can be compensated. In this case, different compensation currents may be impressed on the compensation conductors 141, 142 and thus different magnetic field components in the measurement direction may be superposed on the semiconductor elements 6, 7 and 8, 9 of the various half-bridges.

Finally, in the example of embodiment shown in Fig. 10, a third conductor arrangement 21 is applied above the first and second conductor arrangements 6, 7, 8, 9 and 141, 142, which third conductor arrangement corresponds in terms of its design to that of Fig. 2 and is also once again used as a flip conductor.

The magnetic-field-sensitive sensor arrangement according to the example of embodiment shown in Fig. 9 finally contains a fifth conductor arrangement which comprises one electrical half-bridge with two bridge branches that are insensitive to magnetic fields. This fifth conductor arrangement, which is also referred to as the reference half-bridge, is provided to supply a reference signal that is independent of the magnetic fields and is not shown in the figures. The reference half-bridge is connected to the individual half-bridges of the first conductor arrangement in a predefined operating state of the sensor arrangement to form a bridge circuit. The reference half-bridge is optionally integrated with the first conductor arrangement or preferably with the evaluation circuit.

Fig. 14 shows, as a third example of the design of a stabilizing magnet for use in a magnetic-field-sensitive sensor arrangement according to the invention, a separate representation of the stabilizing magnet 101 as used in a sensor arrangement as shown in Figs. 9 and 10. As an example of the size, such a stabilizing magnet 101 may have external dimensions of 8 mm × 6 mm × 4.5 mm.

Using the sensor arrangement as shown in Figs. 9 and 10, a measurement for example of the oxygen concentration in the medium surrounding the first half-bridge 6, 7 can be carried out according to the following scheme.

In a first operating step, a full bridge is formed by electrically connecting the first half-bridge 6, 7 and the reference half-bridge. The compensation conductors 141,142 do not carry any compensation currents in this operating step. By applying a flip current to the, flip conductor 21, the characteristic of the magnetic-field-sensitive first half-bridge 6, 7 can then be flipped and a bridge output voltage can be measured in the two operating points of the first half-bridge 6, 7 that are thus set, which bridge output voltage is composed of the measurement signal Vo1 of the first half-bridge 6, 7 and the reference signal which is independent of the magnetic fields. The zero offset of the characteristic profile for the measurement signal Vo1- again denoted "offset" - then corresponds to the mean value of the bridge output voltages measured in the two operating points. This measurement is based on conditions comparable to Fig. 7.

In a second operating step, a full bridge is formed by electrically connecting the second half-bridge 8, 9, provided with the cover 502 on the semiconductor substrate 401 and the stabilizing magnet 101, and the reference half-bridge. The compensation conductors 141, 142 still do not carry any compensation currents in this operating step. By applying a flip current to the flip conductor 21, the characteristic of the magnetic-field-sensitive second half-bridge 8, 9 is then flipped and a bridge output voltage is measured in the two operating points of the second half-bridge 8, 9 that are thus set, which bridge output voltage is composed of the measurement signal Vo2 of the second half-bridge 8, 9 and the reference signal. The zero offset of the characteristic profile for the measurement signal Vo2 - again denoted "offset" - then corresponds to the mean value of the bridge output voltages measured in the two operating points. This measurement is also based on conditions comparable to Fig. 7.

In a third operating step, taking into account the zero offsets determined in the first and second operating steps, the full bridge formed in the second operating step can be balanced by means of a second compensation current Icomp2 fed through the second compensation conductor 142. The magnetic field strength in the sensitive direction of the magnetic-field-sensitive semiconductor elements 8, 9 is thus measured directly, so that the temperature coefficient of the magnetic material of the stabilizing magnet 101 is taken into account, that is to say its effect on the measurement is suppressed.

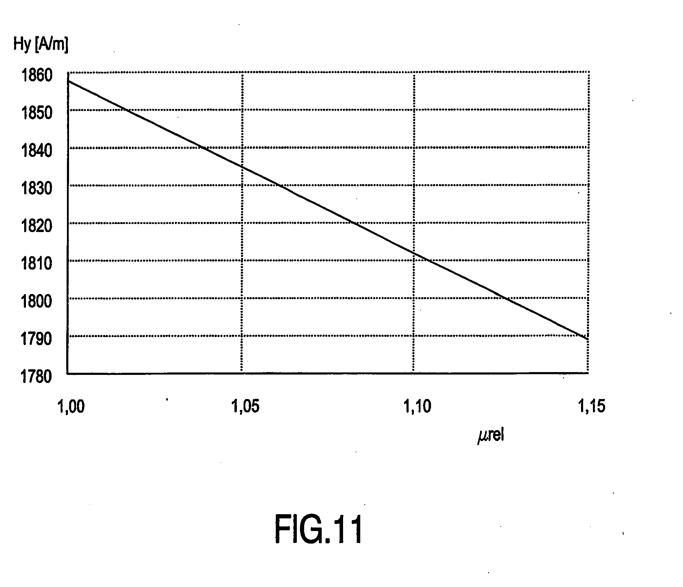

In the fourth operating step, the second compensation current Icomp2 determined in the third operating step is furthermore fed through the second compensation conductor 142 of the covered second half-bridge 8, 9. A first compensation current Icomp1 is then fed through the first compensation conductor 141 of the uncovered first half-bridge 6, 7 and set such that the overall bridge output signal, that is to say the difference in the measurement signals Vo1 and Vo2, becomes zero. A linear dependence between the magnetic field strength Hy in the sensitive direction of the magnetic-field-sensitive semiconductor elements 6, 7 and the relative magnetic permeability of the medium surrounding these semiconductor elements 6, 7 is thus used, as shown in the diagram of Fig. 11. This diagram shows said dependence in the range of values of the relative magnetic permeability µrel passed through by varying the oxygen content of a medium, preferably a gaseous medium, that is to say the modulation of the magnetic field strength Hy of the component of the magnetic field, also referred to as the scattered field, in the sensitive direction by changing the relative magnetic permeability µrel of the surrounding gaseous medium. This linear dependence can thus be used to measure oxygen.

In a fifth operating step, the difference in the two compensation currents Icomp1 and Icomp2 set in the previous operating steps is determined. It is a measure of the oxygen content of the surrounding medium. On the other hand, the second compensation current Icomp2, which flows through the conductor strips 17, 18 of the second compensation conductor 142 below the cover 502, is a direct measure of the possibly temperature- and aging-dependent magnetic field strength of the magnetic field.

If, in the above-described second example of embodiment, the five operating steps are repeated cyclically, homogeneous magnetic interference fields can be suppressed with such a sensor arrangement by a gradiometric design of the semiconductor elements 6, 7, 8, 9 as in the first described example of embodiment. Flipping of the characteristics in this case too allows simple and effective determination and compensation of the zero offset including the temperature-dependence of the latter. By applying a compensation principle using the compensation currents fed through the compensation conductors, the effect of temperature on the measurement sensitivity of the sensor arrangement can be kept low such that it can be disregarded. In addition, the effect of temperature on the remanence of the stabilizing magnet is compensated. Finally, by evaluating the compensation currents in both compensation conductors, it is possible also to evaluate changes in the temperature and oxygen content that occur over time, without requiring an additional temperature measurement

The invention provides a cost-effective miniaturized design of a paramagnetic oxygen sensor by means of which it is possible, given sufficiently high signal deviations and negligible cross-sensitivity, to measure the oxygen content of a gas mixture as required in many fields of application. The use of magnetoresistive elements which use the so-called GMR effect as the magnetoresistive effect is to be preferred because a particularly high measurement sensitivity of the sensor arrangement according to the invention can thereby be achieved.

### LIST OF REFERENCES

- 1: stabilizing magnet with square shape
- 2: surface of the stabilizing magnet 1
- 3: recess in the surface 2 of the stabilizing magnet 1
- 4: semiconductor substrate
- 5: surface of the semiconductor substrate 4 remote from the stabilizing magnet 1
- 6: first magnetic-field-sensitive semiconductor element for the first half-bridge of the first conductor arrangement
- 7: second magnetic-field-sensitive semiconductor element for the first half-bridge of the first conductor arrangement
- 8: third magnetic-field-sensitive semiconductor element for the second half-bridge of the first conductor arrangement
- 9: fourth magnetic-field-sensitive semiconductor element for the second half-bridge of the first conductor arrangement
- 10: first supply voltage terminal
- 11: second supply voltage terminal (e.g. at ground potential)
- 12: first connecting point
- 13: second connecting point
- 14: second conductor arrangement, also referred to as compensation conductor
- 15: first conductor strip of the second conductor arrangement 14 or 141, 142 (for the first semiconductor element 6)
- 16: second conductor strip of the second conductor arrangement 14 or 141, 142 (for the second semiconductor element 7)
- 17: third conductor strip of the second conductor arrangement 14 or 141, 142 (for the third semiconductor element 8)
- 18: fourth conductor strip of the second conductor arrangement 14 or 141, 142 (for the fourth semiconductor element 9)
- 19: first terminal of the second conductor arrangement 14
- 20: second terminal of the second conductor arrangement 14
- 21: third conductor arrangement, also referred to as flip conductor
- 22: first conductor strip of the third conductor arrangement 21 (for the first semiconductor element 6)
- 23: second conductor strip of the third conductor arrangement 21 (for the second semiconductor element 7)
- 24: third conductor strip of the third conductor arrangement 21 (for the third semiconductor element 8)
- 25: fourth conductor strip of the third conductor arrangement 21 (for the fourth semiconductor element 9)
- 26: first terminal of the third conductor arrangement 21
- 27: second terminal of the third conductor arrangement 21

- 100: stabilizing magnet, variation shown in Fig. 13
- 101: stabilizing magnet, variation shown in Fig. 14 ..

- 141: first compensation conductor shown in Fig. 10
- 142: second compensation conductor shown in Fig. 10
- 143: first terminal of the first compensation conductor 141
- 144: second terminal of the first compensation conductor 141
- 145: first terminal of the second compensation conductor 142
- 146: second terminal of the second compensation conductor 142

- 200: surface of stabilizing magnet 100
- 201: surface of stabilizing magnet 101

- 300: recess in the surface 200 of stabilizing magnet 100
- 301: recess in the surface 201 of stabilizing magnet 101

- 401: semiconductor substrate, variation shown in Fig. 10

- 501: surface of the semiconductor substrate 401 remote from the stabilizing magnet 101
- 502: cover on the semiconductor substrate 401 and the stabilizing magnet 101

- H: magnetic field formed by the stabilizing magnet 1
- Hy: magnetic field strength of the measurement field

- Icomp1: first compensation current in the first compensation conductor 141
- Icomp2: second compensation current in the second compensation conductor 142

- Mx: symbolization of the direction of orientation of the magnetic field in the x direction at the location of the sensor arrangement in the representation of the characteristic profile Vo over Hy

- offset: zero offset of the characteristic profile Vo over Hy
- OR: operating range in which the characteristic Vo over Hy is used

- T: temperature of the sensor arrangement, that is to say of the semiconductor substrate 4 with the elements arranged thereon

- Vo: measurement signal
- Vo1: measurement signal of the first half-bridge 6, 7
- Vo2: measurement signal of the second half-bridge 8, 9

- x: insensitive coordinate direction of a Cartesian coordinate system in the surface 5 of the semiconductor substrate 4 of the sensor arrangement

- y: sensitive coordinate direction of a Cartesian coordinate system in the surface 5 of the semiconductor substrate 4 of the sensor arrangement; measurement direction of the sensor arrangement

- z: coordinate direction at right angles to a plane formed by the x- and y-axes

- µrel: relative magnetic permeability of the medium which surrounds the sensor arrangement

## Claims

1. A magnetic-field-sensitive sensor arrangement comprising
- a first conductor arrangement with at least two electrical half-bridges each having at least two bridge branches, at least one of which contains a magnetoresistive element (6, 7, 8, 9), which sensor arrangement supplies a measurement signal depending on the magnetic field strength of a component of a magnetic field (H) at the location of at least one of the half-bridges, this being referred to as the measurement field and being aligned in a measurement direction of the sensor arrangement, and
- a stabilizing magnet (1) which forms the measurement field (H) with a value of its magnetic field strength (Hy), **characterized in that**
the magnetic-field-sensitive sensor arrangement is adapted for determining the content of a particular medium that affects magnetic fields, whereby the medium at least partially surrounds the sensor arrangement, and
the magnetic-field-sensitive sensor arrangement further comprises:
- at least a second conductor arrangement (14) for generating at least a first additional magnetic field component in the measurement direction of the sensor arrangement, and
- at least a third conductor arrangement (21) for generating at least a second additional magnetic field component in a direction which is at least largely at right angles to the measurement direction of the sensor arrangement.

2. A magnetic-field-sensitive sensor arrangement as claimed in claim 1, **characterized in that** the stabilizing magnet (1) has a recess (3) on one of its surfaces (2), via or in which recess (3) the first conductor arrangement is arranged.

3. A magnetic-field-sensitive sensor arrangement as claimed in claim 2, **characterized in that** the stabilizing magnet (1) is magnetized such that the field lines of the magnetic field (H) formed by it emerge essentially vertically from a bottom surface of the recess.

4. A magnetic-field-sensitive sensor arrangement as claimed in any of the preceding claims, **characterized in that** the at least a first additional magnetic field component is provided to superpose and/or compensate a magnetic field externally impressed on the sensor arrangement in the measurement direction.

5. A magnetic-field-sensitive sensor arrangement as claimed in any of the preceding claims, **characterized in that** the at least a second additional magnetic field component is provided to set the operating point of the sensor arrangement.

6. A magnetic-field-sensitive sensor arrangement as claimed in any of the preceding claims, **characterized by** an evaluation circuit to which the measurement signal of the sensor arrangement is fed, and also a temperature measurement device which is coupled to the evaluation circuit and in which a temperature signal is generated that is a measure of the current temperature (T) of the sensor arrangement and/or of the medium surrounding the latter, wherein the temperature signal is likewise fed to the evaluation circuit in order to compensate a temperature-induced change in the measurement signal of the sensor arrangement.

7. A magnetic-field-sensitive sensor arrangement as claimed in claim 6, **characterized in that** the compensation of the temperature-induced change in the measurement signal of the sensor arrangement in the evaluation circuit also comprises the compensation of a temperature-dependence of the stabilizing magnet (1).

8. A magnetic-field-sensitive sensor arrangement as claimed in claim 6, **characterized in that** the compensation of temperature-induced changes in the measurement signal of the sensor arrangement in the evaluation circuit is effected by converting the values of the measurement signal according to a predefined function of the temperature (T).

9. A magnetic-field-sensitive sensor arrangement as claimed in claim 6, **characterized by** at least a fourth conductor arrangement which is coupled to the evaluation circuit and is fed by the latter according to a predefined function of the temperature (T), for impressing at least a third additional magnetic field component for compensating temperature-induced changes in the measurement signal of the sensor arrangement.

10. A magnetic-field-sensitive sensor arrangement as claimed in claim 6, **characterized by** at least a fifth conductor arrangement which comprises at least one electrical half-bridge with at least two bridge branches that are insensitive to magnetic fields, which fifth conductor arrangement is connected to the first conductor arrangement or parts thereof in a predefined operating state of the sensor arrangement to form a bridge circuit.

11. A magnetic-field-sensitive sensor arrangement as claimed in claim 10, **characterized in that** the fifth conductor arrangement is combined with at least the first conductor arrangement to form a common module.

12. A magnetic-field-sensitive sensor arrangement as claimed in claim 10, **characterized in that** the fifth conductor arrangement is combined with at least the evaluation circuit to form a common module.

13. A magnetic-field-sensitive sensor arrangement as claimed in any of the preceding claims, **characterized in that** the medium surrounding the sensor arrangement surrounds the first conductor arrangement only in the region of part of its half-bridges, and **in that** the rest of the sensor arrangement is surrounded by a material which suppresses the effect of the magnetic permeability of the medium on at least one of the half-bridges of the first conductor arrangement.

14. A magnetic-field-sensitive sensor arrangement as claimed in any of the preceding claims, **characterized by** a design for a medium with variable oxygen content.

15. Use of a magnetic-field-sensitive sensor arrangement as claimed in any of the preceding claims for determining the oxygen concentration of a gaseous media that at least partially surrounds said sensor arrangement.

## Patentansprüche

1. Magnetfeldempfindliche Sensoranordnung, umfassend:
eine erste Leiteranordnung mit wenigstens zwei elektrischen Halbbrücken, die jeweils wenigstens zwei Brückenzweige aufweisen, von denen wenigstens einer ein magnetoresistives Element (6, 7, 8, 9) enthält, wobei die Sensoranordnung ein Messsignal liefert, das von der Magnetfeldstärke einer Komponente eines Magnetfeldes (H) am Ort der wenigstens einen der Halbbrücken abhängt, wobei dieses als Messfeld bezeichnet wird und in einer Messrichtung der Sensoranordnung ausgerichtet ist, und
einen Stabilisierungsmagneten (1), der das Messfeld (H) mit einem Wert seiner Magnetfeldstärke (Hy) bildet,
**dadurch gekennzeichnet, dass**
die magnetfeldempfindliche Sensoranordnung so ausgeführt ist, dass sie den Inhalt eines bestimmten Mediums, das Magnetfelder beeinflusst, bestimmt, wobei das Medium wenigstens teilweise die Sensoranordnung umgibt, und
die magnetfeldempfindliche Sensoranordnung ferner umfasst:
wenigstens eine zweite Leiteranordnung (14) zum Erzeugen wenigstens einer ersten zusätzlichen Magnetfeldkomponente in Messrichtung der Sensoranordnung, und
wenigstens eine dritte Leiteranordnung (21) zum Erzeugen wenigstens einer zweiten zusätzlichen Magnetfeldkomponente in einer Richtung, die wenigstens größtenteils rechtwinklig zur Messrichtung der Sensoranordnung ist.

2. Magnetfeldempfindliche Sensoranordnung nach Anspruch 1, **dadurch gekennzeichnet, dass** der Stabilisierungsmagnet (1) eine Vertiefung (3) auf einer seiner Oberflächen (2) aufweist, wobei die erste Leiteranordnung über oder in der Vertiefung (3) angeordnet ist.

3. Magnetfeldempfindliche Sensoranordnung nach Anspruch 2, **dadurch gekennzeichnet, dass** der Stabilisierungsmagnet (1) so magnetisiert ist, dass die Feldlinien des Magnetfeldes (H), das von ihm gebildet wird, im Wesentlichen vertikal aus einer Bodenfläche der Vertiefung austreten.

4. Magnetfeldempfindliche Sensoranordnung nach irgendeinem der vorangehenden Ansprüche, **dadurch gekennzeichnet, dass** die wenigstens eine erste zusätzliche Magnetfeldkomponente vorgesehen ist, um ein Magnetfeld, das von außen der Sensoranordnung in Messrichtung aufgeprägt wird, zu überlagern und/oder zu kompensieren.

5. Magnetfeldempfindliche Sensoranordnung nach irgendeinem der vorangehenden Ansprüche, **dadurch gekennzeichnet, dass** die wenigstens eine zweite zusätzliche Magnetfeldkomponente vorgesehen ist, um den Arbeitspunkt der Sensoranordnung einzustellen.

6. Magnetfeldempfindliche Sensoranordnung nach irgendeinem der vorangehenden Ansprüche, **gekennzeichnet durch** eine Auswertungsschaltung, in die das Messsignal der Sensoranordnung eingegeben wird, und ferner eine Temperaturmessvorrichtung, die mit der Auswertungsschaltung gekoppelt ist und in der ein Temperatursignal erzeugt wird, das ein Maß der aktuellen Temperatur (T) der Sensoranordnung und/oder des diese umgebenden Mediums ist, wobei das Temperatursignal gleichermaßen in die Auswertungsschaltung eingegeben wird, um eine **durch** Temperatur hervorgerufene Änderung des Messsignals der Sensoranordnung zu kompensieren.

7. Magnetfeldempfindliche Sensoranordnung nach Anspruch 6, **dadurch gekennzeichnet, dass** die Kompensation der durch Temperatur hervorgerufenen Änderung des Messsignals der Sensoranordnung in der Auswertungsschaltung auch die Kompensation einer Temperaturabhängigkeit des Stabilisierungsmagneten (1) umfasst.

8. Magnetfeldempfindliche Sensoranordnung nach Anspruch 6, **dadurch gekennzeichnet, dass** die Kompensation der durch Temperatur hervorgerufenen Änderungen im Messsignal der Sensoranordnung in der Auswertungsschaltung bewirkt wird, indem die Werte des Messsignals entsprechend einer vordefinierten Funktion der Temperatur (T) konvertiert werden.

9. Magnetfeldempfindliche Sensoranordnung nach Anspruch 6, **gekennzeichnet durch** wenigstens eine vierte Leiteranordnung, die mit der Auswertungsschaltung gekoppelt ist und **durch** diese entsprechend einer vordefinierten Funktion der Temperatur (T) gespeist wird, um wenigstens eine dritte zusätzliche Magnetfeldkomponente zum Kompensieren der **durch** Temperatur hervorgerufenen Änderungen des Messsignals der Sensoranordnung aufzuprägen.

10. Magnetfeldempfindliche Sensoranordnung nach Anspruch 6, **gekennzeichnet durch** wenigstens eine fünfte Leiteranordnung, die wenigstens eine elektrische Halbbrücke mit wenigstens zwei Brückenzweigen umfasst, die gegenüber Magnetfeldern unempfindlich sind, wobei die fünfte Leiteranordnung mit der ersten Leiteranordnung oder Teilen derselben in einem vordefinierten Betriebszustand der Sensoranordnung verbunden wird, um eine Brückenschaltung zu bilden.

11. Magnetfeldempfindliche Sensoranordnung nach Anspruch 10, **dadurch gekennzeichnet, dass** die fünfte Leiteranordnung mit wenigstens der ersten Leiteranordnung kombiniert ist, um ein gemeinsames Modul zu bilden.

12. Magnetfeldempfindliche Sensoranordnung nach Anspruch 10, **dadurch gekennzeichnet, dass** die fünfte Leiteranordnung mit wenigstens der Auswertungsschaltung kombiniert ist, um ein gemeinsames Modul zu bilden.

13. Magnetfeldempfindliche Sensoranordnung nach irgendeinem der vorangehenden Ansprüche, **dadurch gekennzeichnet, dass** das Medium, das die Sensoranordnung umgibt, die erste Leiteranordnung nur in dem Bereich des Teils seiner Halbbrücken umgibt, und dass der Rest der Sensoranordnung von einem Material umgeben ist, das die Wirkung der magnetischen Permeabilität des Mediums auf wenigstens eine der Halbbrücken der ersten Leiteranordnung unterdrückt.

14. Magnetfeldempfindliche Sensoranordnung nach irgendeinem der vorangehenden Ansprüche, **gekennzeichnet durch** eine Gestaltung für ein Medium mit veränderlichem Sauerstoffgehalt.

15. Verwendung einer magnetfeldempfindlichen Sensoranordnung nach irgendeinem der vorangehenden Ansprüche zum Bestimmen der Sauerstoffkonzentration eines gasförmigen Mediums, das wenigstens teilweise die Sensoranordnung umgibt.

## Revendications

1. Ensemble à capteur sensible aux champs magnétiques comprenant :
- un premier ensemble de conducteurs comportant au moins deux demi-ponts électriques ayant chacun, au moins, deux branches de pont dont l'une au moins contient un élément magnéto résistif (6, 7, 8, 9), lequel ensemble à capteur fournit un signal de mesure dépendant de l'intensité du champ magnétique d'une composante d'un champ magnétique (H) au niveau de la position d'au moins l'un des demi-ponts, celui-ci étant référencé comme le champ de mesure et étant aligné dans une direction de mesure de l'agencement à capteur, et
- un aimant de stabilisation (1) qui crée le champ de mesure (H) avec une valeur de son intensité de champ magnétique (Hy), **caractérisé en ce que** :
l'ensemble à capteur sensible aux champs magnétiques est adapté pour déterminer la teneur en milieu particulier qui affecte les champs magnétiques, de sorte que le milieu entoure, au moins partiellement, l'ensemble à capteur, et
**en ce que** l'ensemble à capteur sensible aux champs magnétiques comprend, de plues :
- au moins un deuxième ensemble de conducteurs (14) pour créer au moins une première composante de champ magnétique supplémentaire dans la direction de mesure de l'ensemble à capteur, et
- au moins un troisième ensemble de conducteurs (21) permettant de créer au moins une seconde composante de champ magnétique supplémentaire dans une direction qui est au moins largement perpendiculaire à la direction de mesure de l'agencement à capteur.

2. Ensemble à capteur sensible aux champs magnétiques selon la revendication 1, **caractérisé en ce que** l'aimant de stabilisation (1) comporte un évidement (3) sur l'une de ses surfaces (2), évidement par l'intermédiaire duquel ou dans lequel (3) le premier ensemble de conducteurs est disposé.

3. Ensemble à capteur sensible aux champs magnétiques selon la revendication 2, **caractérisé en ce que** l'aimant de stabilisation (1) est aimanté de telle sorte que les lignes de champ du champ magnétique (H) créées par lui émergent de façon essentiellement verticale à partir d'une surface inférieure de l'évidement.

4. Ensemble à capteur sensible aux champs magnétiques selon l'une quelconque des revendications précédentes, **caractérisé en ce que** la au moins première composante de champ magnétique supplémentaire est fournie pour se superposer à et/ou pour compenser un champ magnétique appliqué de l'extérieur sur l'ensemble à capteur dans la direction de mesure.

5. Ensemble à capteur sensible aux champs magnétiques selon l'une quelconque des revendications précédentes, **caractérisé en ce que** la au moins deuxième composante de champ magnétique supplémentaire est fournie pour établir le point de fonctionnement de l'ensemble à capteur.

6. Ensemble à capteur sensible aux champs magnétiques selon l'une quelconque des revendications précédentes, **caractérisé par** un circuit d'évaluation auquel le signal de mesure de l'ensemble à capteur est fourni, et également un dispositif de mesure de température qui est couplé au circuit d'évaluation et dans lequel un signal de température est généré qui est une mesure de la température en cours (T) de l'ensemble à capteur et/ou du milieu entourant celui-ci, dans lequel le signal de température est fourni de la même manière au circuit d'évaluation afin de compenser une variation induite en température dans le signal de mesure de l'ensemble à capteur.

7. Ensemble à capteur sensible aux champs magnétiques selon la revendication 6, **caractérisé en ce que** la compensation de la variation induite en température dans le signal de mesure de l'ensemble à capteur dans le circuit d'évaluation comprend également la compensation d'une dépendance en température de l'aimant de stabilisation (1).

8. Ensemble à capteur sensible aux variations magnétiques selon la revendication 6, **caractérisé en ce que** la compensation des variations induites en température dans le signal de mesure de l'ensemble à capteur dans le circuit d'évaluation est effectuée en convertissant les valeurs du signal de mesure selon une fonction prédéfinie de la température (T).

9. Ensemble à capteur sensible aux champs magnétiques selon la revendication 6, **caractérisé par** au moins un quatrième ensemble de conducteurs qui est couplé au circuit d'évaluation et est fourni par ce dernier selon une fonction prédéfinie de la température (T), pour appliquer au moins une troisième composante de champ magnétique supplémentaire afin de compenser des variations induites en température dans le signal de mesure de l'ensemble à capteur.

10. Ensemble à capteur sensible aux champs magnétiques selon la revendication 6, **caractérisé par** au moins un cinquième ensemble de conducteurs qui comprend au moins un demi-pont électrique comportant au moins deux branches de pont lesquelles ne sont pas sensibles aux champs magnétiques, lequel cinquième ensemble de conducteurs est connecté au premier ensemble de conducteurs ou à des parties de celui-ci dans un état fonctionnel prédéfini de l'ensemble à capteur afin de former un circuit en pont.

11. Ensemble à capteur sensible aux champs magnétiques selon la revendication 10, **caractérisé en ce que** le cinquième ensemble de conducteurs est combiné avec au moins le premier ensemble de conducteurs pour former un module commun.

12. Ensemble à capteur sensible aux champs magnétiques selon la revendication 10, **caractérisé en ce que** le cinquième ensemble de conducteurs est combiné avec au moins le circuit d'évaluation afin de former un module commun.

13. Ensemble à capteur sensible aux champs magnétiques selon l'une quelconque des revendications précédentes, **caractérisé en ce que** le milieu entourant l'ensemble à capteur entoure le premier ensemble de conducteurs seulement dans la zone d'un élément de ses demi-ponts, et **en ce que** le reste de l'ensemble à capteur est entouré d'un matériau qui supprime l'effet de la perméabilité magnétique du milieu sur au moins l'un des demi-ponts du premier ensemble de conducteurs.

14. Ensemble à capteur sensible aux champs magnétiques selon l'une quelconque des revendications précédentes, **caractérisé par** un concept destiné à un milieu présentant une teneur variable en oxygène.

15. Utilisation d'un ensemble à capteur sensible aux champs magnétiques selon l'une quelconque des revendications précédentes servant à déterminer la concentration en oxygène de milieux gazeux qui entourent, au moins en partie, ledit ensemble à capteur.
